(19) Europäisches Patentamt
European Patent Office
Office européen des brevets

(11) EP 3 859 835 A1

(12) **EUROPEAN PATENT APPLICATION**
published in accordance with Art. 153(4) EPC

(43) Date of publication:
**04.08.2021 Bulletin 2021/31**

(21) Application number: **19883788.2**

(22) Date of filing: **11.11.2019**

(51) Int Cl.:
***H01M 4/36*** *(2006.01)* ***H01M 4/38*** *(2006.01)*
***H01M 4/48*** *(2010.01)* ***H01M 4/587*** *(2010.01)*
***H01M 4/62*** *(2006.01)* ***H01M 10/052*** *(2010.01)*
***C23C 16/18*** *(2006.01)* ***C23C 16/26*** *(2006.01)*
***C23C 16/448*** *(2006.01)*

(86) International application number:
**PCT/KR2019/015245**

(87) International publication number:
**WO 2020/101301 (22.05.2020 Gazette 2020/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **13.11.2018 KR 20180139256**

(71) Applicant: **LG ENERGY SOLUTION, LTD.**
**Seoul 07335 (KR)**

(72) Inventors:
- **KIM, Dong Hyuk**
**Daejeon 34122 (KR)**
- **OH, Il Geun**
**Daejeon 34122 (KR)**
- **LEE, Yong Ju**
**Daejeon 34122 (KR)**
- **PARK, Se Mi**
**Daejeon 34122 (KR)**

(74) Representative: **Hoffmann Eitle**
**Patent- und Rechtsanwälte PartmbB**
**Arabellastraße 30**
**81925 München (DE)**

# (54) ANODE ACTIVE MATERIAL AND MANUFACTURING METHOD THEREFOR

(57) An negative electrode active material includes: a silicon based particle; a carbon coating layer formed on a surface of the silicon based particle and including a transition metal; and carbon nanotubes (CNT), wherein one ends of the carbon nanotubes are connected to the transition metal, and a content of the transition metal is 0.03 to 30 parts by weight based on 100 parts by weight of a sum of the carbon coating layer and the carbon nanotubes.

【FIG. 1】

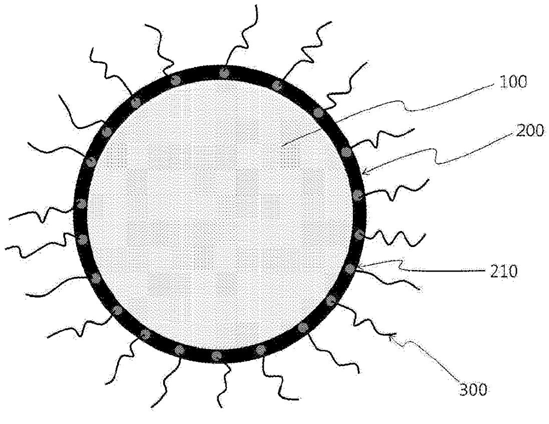


EP 3 859 835 A1

## Description

[Technical Field]

Cross Reference to Related Applications

This application is based on and claims the benefit of priority to Korean Patent Application No. 10-2018-0139256, filed on November, 13, 2018 in the Korean Intellectual Property Office, the disclosure of which is incorporated herein in its entirety by reference.

Technical Field

The present disclosure relates to a negative electrode active material and a method of preparing the same, and more particularly, to a negative electrode active material in which a carbon coating layer and carbon nanotubes (CNT) are positioned on a surface of a silicon based particle and a method of preparing the same.

[Background Art]

Due to rapid increase in use of fossil fuel, the demand for use of alternative energy or clean energy has been increased. As a part of this, the most actively researched fields are power generation and electricity storage fields using electrochemical reactions.

Currently, as a representative example of an electrochemical device using electrochemical energy as described above is a secondary battery, and a use area of the secondary battery is gradually increasing. Currently, as the technical development and demand for portable apparatus such as a portable computer, a portable phone, a camera, and the like have been increased, the demand for the secondary battery as an energy source has been rapidly increased. Among these secondary batteries, a lithium secondary battery having a high energy density, that is, a high capacity lithium secondary battery has been studied a lot and commercialized to thereby be widely used.

Generally, the secondary battery is composed of a positive electrode, a negative electrode, an electrolyte, and a separator. As a positive electrode active material constituting a positive electrode of a lithium secondary battery, metal oxides such as $LiCoO_2$, $LiMnO_2$, $LiMn_2O_4$, or $LiCrO_2$, are used, and as a negative electrode active material constituting a negative electrode, a metal lithium, a carbon based material such as graphite, activated carbon, or the like, a silicon oxide ($SiO_x$), and the like, are used. Among the negative electrode active materials, metal lithium was initially mainly used. However, as charge and discharge cycles proceed, lithium atoms grow on a surface of metal lithium to damage a separator to thereby damage a battery. Therefore, recently, the carbon based material is mainly used. However, in the case of the carbon based material, theoretical capacity is only about 400 mAh/g, such that the carbon based material has a disadvantage in that capacity is small. Therefore, various researches for substituting the carbon based material with a high-capacity material such as silicon (Si) having high theoretical capacity (4,200 mAh/g), or the like, as the negative electrode active material have been conducted.

However, a material having high capacity has problems in that an electrical short-circuit is generated in an electrode due to an excessive volume change during a charge and discharge process, and performance of a battery is deteriorated due to growth of a thick and unstable solid electrolyte interphase (SEI).

In the related art, in order to solve these problems, a conductive material has been additionally used, or a method of introducing various conductive materials such as carbon nanotubes (CNT), and the like, has been attempted.

However, in the case of additionally using the conductive material, there is a problem in that when a content of the conductive material is increased, aggregation between the conductive materials is generated, and in the case of using the carbon nanotubes when silicon is used together the carbon based material as the negative electrode active material, there is a problem in that the carbon nanotubes are not present only on silicon, but are uniformly distributed in an entire electrode, such that efficiency is decreased.

Therefore, there is a need to develop a novel technology capable of significantly increasing an effect at the time of applying the carbon nanotubes to a silicon based negative electrode active material.

**[Disclosure of Invention]**

[Technical Problem]

An aspect of the present disclosure provides a negative electrode active material having excellent conductivity without an electrical short-circuit problem caused by volume expansion of the negative electrode active material in an electrode.

Another aspect of the present disclosure provides a method of preparing the negative electrode active material.

Another aspect of the present disclosure provides a negative electrode for a lithium secondary battery including the negative electrode active material, and a lithium secondary battery including the negative electrode.

[Technical Solution]

According to an exemplary embodiment of the present disclosure, a negative electrode active material includes: a silicon based particle; a carbon coating layer formed on a surface of the silicon based particle and including a transition metal; and carbon nanotubes (CNT), wherein one ends of the carbon nanotubes are connected to the transition metal, and a content of the transition metal is 0.03 to 30 parts by weight based on 100 parts by weight of a sum of the carbon coating layer and the carbon nanotubes.

According to another exemplary embodiment of the present disclosure, a method of preparing a negative electrode active material includes: preparing a mixture including a transition metal compound and a carbon source; and forming a carbon coating layer including a transition metal and carbon nanotubes (CNT) on a surface of a silicon based particle by performing chemical vapor deposition of the mixture on the surface of the silicon based particle, wherein a content of the transition metal is 0.03 to 30 parts by weight based on 100 parts by weight of a sum of the carbon coating layer and the carbon nanotubes.

According to another exemplary embodiment of the present disclosure, a negative electrode for a lithium secondary battery includes the negative electrode active material, and a secondary battery includes the negative electrode.

[Advantageous Effects]

Since a negative electrode active material according to the present disclosure includes a carbon coating layer including a transition metal and formed on a surface of a silicon based particle and carbon nanotubes of which one ends are connected to the transition metal, the carbon nanotubes are firmly bonded to the surface of the silicon based particle, such that the carbon nanotubes may continuously provide electrical conductivity in spite of a volume change of the silicon based particle, thereby making it possible to maintain excellent conductivity.

[Description of Drawings]

FIG. 1 is a view briefly illustrating a cross section of a negative electrode active material according to an exemplary embodiment of the present disclosure.

[Best Mode]

Hereinafter, the present disclosure will be described in more detail, in order to assist in the understanding of the present disclosure. Terms and words used in the present specification and claims are not to be construed as a general or dictionary meaning but are to be construed meaning and concepts meeting the technical ideas of the present disclosure based on a principle that the inventors can appropriately define the concepts of terms in order to describe their own disclosures in best mode.

An negative electrode active material according to the present disclosure includes: a silicon based particle; a carbon coating layer formed on a surface of the silicon based particle and including a transition metal; and carbon nanotubes (CNT), wherein one ends of the carbon nanotubes are connected to the transition metal, and a content of the transition metal is 0.03 to 30 parts by weight based on 100 parts by weight of a sum of the carbon coating layer and the carbon nanotubes.

Since a volume change of the silicon based particle caused by contraction and expansion at the time of charge and discharge is large, there is a problem in that an electrical path in an electrode is blocked and thus, cycle characteristics of an electrode are deteriorated. Therefore, carbon nanotubes capable of being in linear contact with the silicon based particle to provide a stable electrical path and capable of being positioned so as to cross two or more silicon based particles to increase electrical contacts between the silicon based particles may be used as the conductive material.

Since the volume change of the silicon based particle caused by contraction and expansion at the time of charge and discharge is large, the silicon based particle is often mixed and used with a carbon based particle of which a volume change is small, for example, graphite, or the like. However, when the silicon based particle (silicon based active material) is mixed and used with the carbon based active material, in order to solve an electrical short-circuit due to the volume change of the silicon based particle, in the case of introducing the carbon nanotubes at the time of preparing negative electrode slurry, since the carbon nanotubes are evenly distributed on the entire negative electrode as well as

a surface of a silicon based particle requiring use of the carbon nanotubes, an effect thereof is not large as compared to a use amount of the carbon nanotubes.

Further, generally, it is difficult to disperse the carbon nanotubes in a solvent, such that in the case of introducing the carbon nanotubes in the negative electrode, due to an aggregation phenomenon due to attractive force between carbon nanotubes, it is difficult to introduce carbon nanotubes in a shape in which the carbon nanotubes are uniformly dispersed.

Therefore, in the present disclosure, in order to introduce the carbon nanotubes in the silicon based particle, the carbon nanotubes may be allowed to more effectively impart conductivity to the silicon based particle by connecting the carbon nanotubes to the transition metal formed on the surface of the silicon based particle.

The carbon nanotube has one end connected to the transition metal, and one end thereof connected to the transition metal may come in contact with the carbon coating layer or be embedded in the carbon coating layer. One ends of the carbon nanotubes come in contact with the carbon coating layer or are embedded in the carbon coating layer as described above, which is caused that the transition metals to which one ends of the carbon nanotube are connected are included in the carbon coating layer in a form in which the transition metals are positioned on the surface of the carbon coating layer or embedded in the carbon coating layer, or some of the transition metals are exposed to the surface of the carbon coating layer and some thereof are embedded in the carbon coating layer. Meanwhile, the other end of the carbon nanotube is positioned outside the surface of the carbon coating layer.

Since one end of the carbon nanotube is connected to the transition metal and the transition metal is included in the carbon coating layer, the carbon nanotube is firmly attached to the surface of the silicon based particle to thereby stably impart electrical conductivity in spite of the volume change of the silicon based particle, it is possible to minimize a phenomenon that an electrical network is disconnected due to a volume change, a position, or a shape change of a negative electrode active material, and it is possible to suppress resistance of a negative electrode from being increased in accordance with disconnection of the electrical network. In addition, the other end of the carbon nanotube is positioned outside the surface of the carbon coating layer to come in contact with another negative electrode active material or a current collector, thereby making it possible to provide an electrical path between the negative electrode active materials in a negative electrode and an electrical path between the negative electrode and the current collector. Since the carbon nanotube may serve to provide a path in which the carbon nanotube reacts with lithium ions in the negative electrode due to significantly excellent electrical conductivity and lithium ion conductivity, it is possible to uniformly maintain current and voltage distribution in an electrode during charge and discharge cycles to significantly improve cycle characteristics.

A content of the carbon coating layer may be 0.1 parts by weight to 20 parts by weight, specifically, 0.5 parts by weight to 15 parts by weight, and more specifically, 1 part by weight to 10 parts by weight based on 100 parts by weight of the silicon based particle. When the content of the carbon coating layer is within the above-mentioned range, the carbon coating layer may impart more suitable conductivity to the silicon based particle and more effectively decrease the volume change of the silicon based particle.

A thickness of the carbon coating layer may be 1 nm to 1 μm, specifically, 5 nm to 500 nm, and more specifically, 10 nm to 200 nm. When the thickness of the carbon coating layer is within the above-mentioned range, the carbon coating layer may more effectively decrease the volume change of the silicon based particle.

The carbon nanotube may have a length of 0.1 μm to 100 μm, specifically 0.5 μm to 50 μm, and more specifically, 1 μm to 20 μm. When the length of the carbon nanotube is within the above-mentioned range, the carbon nanotube may impart more suitable conductivity and more effectively maintain the electrical path in the negative electrode in spite of a volume change of silicon.

The transition metal included in the carbon coating layer may be one or more selected from the group consisting of Cr, Mn, Fe, Co, Ni, and V, and specifically, one more selected from the group consisting of Fe, Co, and Ni.

The transition metal may be derived from a transition metal compound used in a process of forming the carbon coating layer and the carbon nanotube.

The transition metal compound may be a metallocene compound capable of including a transition metal capable of serving as a catalyst for growth of the carbon nanotubes, and specifically, the transition metal compound may be a compound represented by the following Chemical Formula 1.

[Chemical Formula 1]

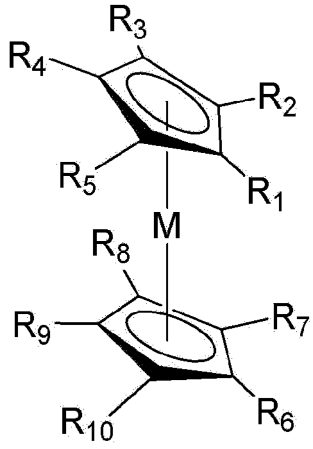

In Chemical Formula 1,

$R_1$ to $R_{10}$ are each independently hydrogen; halogen; silyl; (C1-C20)alkyl; (C3-C20)cycloalkyl; (C2-C20)alkenyl; (C1-C20)alkoxy; (C6-C20)aryl substituted or unsubstituted with halogen, (C1-C12)alkyl, (C3-C12)cycloalkyl, (C1-C8)alkoxy, or (C6-C12)aryl; or (C7-C20)arylalkyl substituted or unsubstituted with halogen, (C1-C12)alkyl, (C3-C12)cycloalkyl, (C1-C8)alkoxy, or (C6-C12)aryl; two or more of $R_1$ to $R_{10}$ may be linked with each other to form a ring, and
M is V, Cr, Mn, Fe, Co, or Ni.

Further, $R_1$ to $R_{10}$ are each independently hydrogen; halogen; (C1-C12)alkyl; (C3-C20)cycloalkyl; (C2-C20)alkenyl; (C6-C20)aryl; (C7-C20)alkylaryl; or (C7-C20)arylalkyl, two or more of $R_1$ to $R_{10}$ may be linked with each other to form a ring, and
M is Fe, Co, or Ni.

More specifically, the compound represented by Chemical Formula 1 may be $n_5$-$(C_5H_5)_2Fe$, $n_5$-$(C_5H_5)_2Co$, or $n_5$-$(C_5H_5)_2Ni$.

Unless described otherwise, the term 'halogen' used in the present specification means fluorine, chlorine, bromine, or iodine.

Unless described otherwise, the term 'alkyl' used in the present specification means a linear, cyclic, or branched hydrocarbon residue, and non-restrictive example thereof include methyl, ethyl, n-propyl, isopropyl, n-butyl, isobutyl, t-butyl, n-pentyl, isopentyl, and hexyl.

Unless described otherwise, the term 'cycloalkyl' used in the present specification means a non-aromatic cyclic hydrocarbon radical composed of carbon atoms. Non-restrictive examples of 'cycloalkyl' include cyclopropyl, cyclobutyl, cyclopentyl, cyclohexyl, and cycloheptyl.

Unless described otherwise, the term 'aryl' used in the present specification means an arbitrarily substituted benzene ring or a ring system formed by fusing one or more arbitrary substituents. The ring or ring system as described above may be arbitrarily fused with an aryl ring (for example, a benzene ring), a carbocylic ring, or heterocyclic ring having one or more substituents. Non-restrictive examples of 'aryl' include phenyl, naphthyl, tetrahydronaphthyl, biphenyl, indanyl, anthracyl, or phenanthryl, and substituted derivatives thereof.

The term 'alkenyl' used in the present specification means a linear or branched hydrocarbon radical having one or more carbon-carbon double bonds. Examples of alkenyl used in the present disclosure include ethenyl and propenyl, but are not limited thereto.

The term 'alkoxy' used in the present specification indicates an $-OR_a$ group, wherein $R_a$ is the above-defined alkyl. Non-restrictive examples of 'alkoxy' include methoxy, difluoromethoxy, trifluoromethoxy, ethoxy, n-propoxy, isopropoxy, n-butoxy, and t-butoxy.

The transition metal included in the transition metal compound may serve as the catalyst for growth of the carbon nanotube, and a carbon compound included in the transition metal compound may provide carbon for forming the carbon coating layer and the carbon nanotubes.

A content of the transition metal may be 0.03 parts by weight to 30 parts by weight based on 100 parts by weight of a sum of the carbon coating layer and the carbon nanotubes, and when the content of the transition metal is within the above-mentioned range, the carbon nanotubes having a content enough to impart more suitable conductivity

to the silicon based particle may be grown therefrom and connected thereto. Since the higher the content of the transition metal, the higher the content of carbon nanotubes grown therefrom, there is a need to suitably adjust the content of the transition metal in the negative electrode active material. When the content of the transition metal is less than 0.03 parts by weight, the content of the carbon nanotube grown therefrom is small, such that it is difficult to form an electrical network at a desirable level, and it is difficult to implement an effect of improving life performance. When the content of the transition metal is more than 30 parts by weight, the content of the carbon nanotubes grown therefrom is excessively high, such that there is a risk that capacity of the negative electrode active material will be decreased.

The content of the transition metal may be preferably 0.05 parts by weight to 10 parts by weight, and more preferably 0.1 part by weight to 5 parts by weight based on 100 parts by weight of the sum of the carbon coating layer and the carbon nanotubes. The content of the transition metal is within the above-mentioned range, which is preferable in that an effect of improving capacity of the negative electrode active material, an effect of improving initial efficiency, and an effect of improving life characteristics may be simultaneously implemented.

The linear conductive material may be a material forming a fibrous structure while being electrochemically stable and having excellent conductive, and may be one or more selected from the group consisting of carbon fiber, carbon nanofiber (CNF), metal fiber, carbon nanotube (CNT), and conductive whiskers, specifically carbon fiber, and more specifically, carbon nanotube (CNT).

The silicon based particle may be one or more selected from the group consisting of Si, $SiO_x(0<x<2)$, and M-$SiO_y$ (M=Li, Mg, Ca, Al, or Ti, and $0\leq y<2$), specifically, M-$SiO_y$. M-$SiO_y$ includes one or more selected from the group consisting of a Si phase, a $SiO_2$ phase, a metal oxide phase, and a metal silicate phase. The metal silicate may be one or more selected from the group consisting of $Li_2Si_2O_5$, $Li_3SiO_3$, $Li_4SiO_4$, $Mg_2SiO_4$, and $MgSiO_3$.

In the case in which M-$SiO_y$ is included as the silicon based particle, life characteristics may be excellent as compared to silicon (Si), volume expansion at the time of charge and discharge may be relatively small, and initial efficiency may be more excellent as compared to $SiO_x$.

An average particle size (D50) of the silicon based particle may be 0.5 to 30 $\mu$m, specifically, 1 to 10 $\mu$m. When an average particle size of the silicon based particle is within the above-mentioned range, the negative electrode may have a suitable density to thereby have a suitable capacity per volume, and it is possible to prevent a thickness of the negative electrode from being excessively thickened due to volume expansion of the negative electrode active material.

The negative electrode active material according to the exemplary embodiment of the present disclosure may have an average particle size ($D_{50}$) of 0.5 to 30 $\mu$m, specifically, 2 to 30 $\mu$m, and more specifically, 4 to 20 $\mu$m. When the average particle size of the negative electrode active material is within the above-mentioned range, the negative electrode may have a suitable density to thereby have a suitable capacity per volume, and it is possible to prevent a thickness of the negative electrode from being excessively thickened due to volume expansion of the negative electrode active material.

In the present disclosure, the average particle size ($D_{50}$) of the negative electrode active material may be defined as an average particle size based on 50% of particle size distribution. The average particle size may be measured, for example, using a laser diffraction method or a scanning electron microscope (SEM) photograph, but is not particularly limited. In the laser diffraction method, an average particle size in a range of about submicron to several mm may be measured, and results with high reproducibility and high resolvability may be obtained.

FIG. 1 is a view briefly illustrating a cross section of the negative electrode active material according to the exemplary embodiment of the present disclosure.

As shown in FIG. 1, the negative electrode active material according to the exemplary embodiment of the present disclosure includes a carbon coating layer 200 formed on a surface of a silicon based particle 100 and including a transition metal 210; and carbon nanotubes 300 of which one ends are connected to the transition metal 210, wherein the other ends of the carbon nanotubes 300 are exposed to the outside of a surface of the carbon coating layer 200.

In the case in which the negative electrode active material according to the exemplary embodiment of the present disclosure is included in a negative electrode, the other end of the carbon nanotube 300 exposed to the outside of the surface of the carbon coating layer 200 may come in contact with a carbon nanotube or the carbon coating layer of another negative electrode active material except for the illustrated negative electrode active material or come in contact with an active material, a conductive material, or the like, that may be additionally added in addition to the negative electrode active material according to the exemplary embodiment of the present disclosure, thereby forming an electrical path.

The negative electrode active material according to the exemplary embodiment of the present disclosure may be prepared by a method of preparing a negative electrode active material including: preparing a mixture including a transition metal compound and a carbon source; and forming a carbon coating layer including a transition metal and carbon nanotubes (CNT) on a surface of a silicon based particle by performing chemical vapor deposition of the mixture on the surface of the silicon based particle, wherein a content of the transition metal is 0.03 to 30 parts by weight based on 100 parts by weight of a sum of the carbon coating layer and the carbon nanotubes, and the present disclosure provides the method of preparing a negative electrode active material described above.

Growth of the carbon nanotube may occur using the transition metal of the transition metal compound as a catalyst and the carbon source and hydrocarbon of the transition metal compound as raw materials.

As described above, the transition metal compound may be a metallocene compound capable of including a transition metal capable of serving as a catalyst for growth of the carbon nanotubes, and specifically, the transition metal compound may be a compound represented by the following Chemical Formula 1.

[Chemical Formula 1]

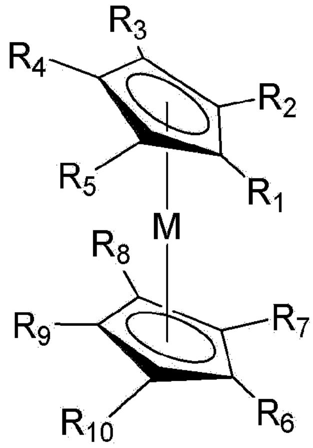

In Chemical Formula 1, $R_1$ to $R_{10}$ are the same as described above.

The carbon source may be alcohol based solvent, specifically, one or more selected from the group consisting of methanol, ethanol, propanol, and butanol, and the carbon source may serve as a solvent for dispersing or dissolving the transition metal compound.

In the preparing of the mixture including the transition metal compound and the carbon source in the method of preparing a negative electrode active material according to the present disclosure may include dispersing or dissolving the transition metal compound in the carbon source, that is, the alcohol based solvent.

A content of the transition compound may be 0.01 wt% to 10 wt%, specifically 0.05 wt% to 5 wt%, and more specifically, 0.1 wt% to 3 wt% based on the entire mixture. When the content of the transition metal compound is within the above-mentioned range, the carbon coating layer may be manufactured so as to satisfy the above-mentioned content and thickness and the carbon nanotubes may be manufacture so as to satisfy the above-mentioned content and thickness, such that the carbon coating layer may be more effectively decrease a volume change of the silicon based particle, and the carbon nanotubes may provide a sufficient electrical contact path while suitably maintaining conductivity of a negative electrode, whereby a secondary battery including the negative electrode active material according to the present disclosure may exhibit more excellent cycle characteristics.

Chemical vapor deposition (CVD) may be performed using the mixture in a liquid mist form as a raw material. For example, in the case of mixing the transition metal compound with the carbon source, preparing the mixture in a mist form using a mist generator or an ultrasonic atomizer, putting the silicon particle into a CVD chamber, and then blowing the mist into a hot zone using a carrier gas, the mist may be pyrolyzed at a high temperature to form the carbon coating layer on the surface of the silicon particle, and as metallocene in the mist is pyrolyzed, metal nanoparticles are formed and growth of CNT occurs using the metal nanoparticles as a catalyst.

The carrier gas may be an inert gas. Specifically, the carrier gas may be at least one selected from the group consisting of Ar, He, and Ne, and more specifically, the carrier gas may be Ar.

The carbon source of the mixture and hydrocarbon of the transition metal compound are carbonized, such that carbon coating layer may be formed on the surface of the silicon based particle. Further, the carbon nanotube may grow from the transition metal to be formed, such that the carbon nanotube may be connected to the transition metal. The carbon nanotube may continuously grow toward the outside of the surface of the carbon coating layer regardless of the thickness of the carbon coating layer, such that the other end thereof may be positioned outside the surface of the carbon coating layer.

The content of the transition metal included in the carbon coating layer may be adjusted depending on a chemical vapor deposition time. As the chemical vapor deposition time is increased, the content of the transition metal is also increased.

The chemical vapor deposition may be performed for 6 seconds to 300 minutes, specifically, 30 seconds to

100 minutes, and more specifically, 1 minute to 5 minutes. When the chemical vapor deposition time is within the above-mentioned range, the transition metal may be included in the carbon coating layer at a suitable content, and a suitable content of carbon nanotube may grow therefrom.

Further, the present disclosure provides a negative electrode including the negative electrode active material. The negative electrode may include a current collector and a negative electrode active material layer disposed on the current collector. The negative electrode active material layer may include the negative electrode active material.

The negative electrode active material layer may include the negative electrode active material and a binder and additionally include a conductive material. In addition, the negative electrode active material layer may additionally include a carbon based negative electrode active material in addition to the negative electrode active material.

Examples of the carbon based negative electrode active material may include natural graphite, kish graphite, pyrolytic carbon, mesophase pitch based carbon fiber, mesocarbon microbeads, mesophase pitches, soft carbon, hard carbon, non-graphitizing carbon, graphitizing carbon, high-temperature baked carbon such as petroleum or coal tar pitch derived cokes.

The negative electrode active material according to the present disclosure and the carbon based negative electrode active material except for the negative electrode active material may be included in a weight ratio of 1:99 to 90:10, specifically, 1:99 to 70:30, and more specifically, 2:98 to 50:50.

When the negative electrode active material and the carbon based negative electrode active material capable of being additionally used satisfy the weight ratio described above, high capacity, excellent initial efficiency, and excellent cycle characteristics may be suitably harmonized.

The binder may include at least one selected from the group consisting of a polyvinylidenefluoride-hexafluoropropylene copolymer (PVDF-co-HFP), polyvinylidenefluoride, polyacrylonitrile, polymethylmethacrylate, polyvinylalcohol, carboxymethyl cellulose (CMC), starch, hydroxypropyl cellulose, regenerated cellulose, polyvinylpyrrolidone, polytetrafluoroethylene, polyethylene, polypropylene, an ethylene-propylene-diene monomer (EPDM), sulfonated EPDM, styrene butadiene rubber (SBR), fluorine rubber, polyacrylic acid, and materials in which hydrogen of the above-mentioned material is substituted with Li, Na, Ca, or the like, and include various copolymers thereof.

An example of a solvent for forming the negative electrode active material layer of the negative electrode may include organic solvents such as N-methyl-pyrrolidone (NMP), dimethyl formamide (DMF), acetone, and dimethyl acetamide, water, or the like. One of these solvent may be used alone, or a mixture of two or more thereof may be used.

The conductive material is not particularly limited as long as it does not cause chemical changes in the battery and has conductivity. For example, graphite such as natural graphite or artificial graphite; carbon black such as carbon black, acetylene black, ketjen black, channel black, furnace black, lamp black, or thermal black; conductive fibers such as carbon fibers and metallic fibers; conductive tubes such as carbon nanotubes; fluorocarbon; metal powders such as, aluminum powder, and nickel powder; conductive whiskers of zinc oxide and potassium titanate; conductive metal oxides such as titanium oxide; conductive materials such as polyphenylene derivatives; and the like may be used as the conductive material.

The current collector is not particularly limited as long as it does not cause chemical changes in the corresponding battery and has conductivity. For example, as the current collector, copper, stainless steel, aluminum, nickel, titanium, baked carbon, or a material in which a surface of aluminum or stainless steel is surface-treated with carbon, nickel, titanium, silver, or the like, may be used. In detail, a transition metal that adsorbs carbon well such as copper or nickel may be used as the current collector. A thickness of the current collector may be 6 $\mu$m to 20 $\mu$m, but is not limited thereto.

Further, the present disclosure provides a secondary battery including the negative electrode. The secondary battery may include the negative electrode, a positive electrode, a separator interposed between the negative electrode and the positive electrode, and an electrolyte. Since the negative electrode is described in detail, a detailed description thereof will be omitted.

The positive electrode may include a positive electrode current collector and a positive electrode active material layer formed on the positive electrode current collector and including a positive electrode active material.

In the positive electrode, the positive electrode current collector is not particularly limited as long as it does not cause chemical changes in the battery and has conductivity. For example, stainless steel, aluminum, nickel, titanium, baked carbon, aluminum or stainless steel surface-treated with carbon, nickel, titanium, or silver, or the like, may be used. Further, the positive electrode current collector may generally have a thickness of 3 $\mu$m to 500 $\mu$m, and adhesion force of the positive electrode active material may be increased by forming fine unevenness on a surface of the current collector. For example, the positive electrode current collector may be used in various forms including films, sheets, foils, nets, porous structures, foams, non-woven fabrics, and the like.

The positive electrode active material may be a generally used positive electrode active material. In detail, examples of the positive electrode active material may include layer compounds or compound substituted with one or more transition metals such as lithium cobalt oxide ($LiCoO_2$), lithium nickel oxide ($LiNiO_2$) , $Li[Ni_xCo_yMn_zMv]O_2$ (here, M is one or two or more elements selected from the group consisting of Al, Ga, and In; and $0.3 \le x < 1.0$, $0 \le y$, $z \le 0.5$, $0 \le v \le 0.1$, and $x+y+z+v=1$), $Li(Li_aM_{b-a-b'}M'_{b'})O_{2-c}A_c$ (here, $0 \le a \le 0.2$, $0.6 \le b \le 1$, $0 \le b' \le 0.2$, $0 \le c \le 0.2$; M include one or more

selected from the group consisting of Mn, Ni, Co, Fe, Cr, V, Cu, Zn, Ti; M' is one or more selected from the group consisting of Al, Mg, and B, and A is one or more selected from the group consisting of P, F, S, and N); lithium manganese oxides such as lithium manganese oxide represented by Chemical Formula $Li_{1+y}Mn_{2-y}O_4$ (here, y is 0 to 0.33), $LiMnO_3$, $LiMn_2O_3$, $LiMnO_2$, and the like; lithium copper oxide ($Li_2CuO_2$) ; vanadium oxides such as $LiV_3O_8$, $LiFe_3O_4$, $V_2O_5$, $CU_2V_2O_7$, and the like; Ni site type lithium nickel oxide represented by Chemical Formula $LiNi_{1-y}M_yO_2$ (here, M is Co, Mn, Al, Cu, Fe, Mg, B, or Ga, and y is 0.01 to 0.3); lithium manganese composite oxide represented by Chemical Formula $LiMn_{2-y}M_yO_2$ (here, M is Co, Ni, Fe, Cr, Zn, or Ta, and y is 0.01 to 0.1) or $Li_2Mn_3MO_8$ (here, M is Fe, Co, Ni, Cu, or Zn); $LiMn_2O_4$ in which some of lithium atoms are substituted with alkaline earth metal ions; disulfide compounds; $Fe_2(MoO_4)_3$, and the like, but are not limited thereto. The positive electrode may be a lithium metal.

The positive electrode active material layer may further include a positive electrode conductive material and a positive electrode binder in addition to the above-mentioned positive electrode active material.

Here, the positive electrode conductive material is used to impart conductivity to an electrode and is not particularly limited as long as it does not cause chemical changes in a battery to be manufactured and has electron conductivity. Specific example thereof may include graphite such as natural graphite or artificial graphite; carbon based material such as carbon black, acetylene black, ketjen black, channel black, furnace black, lamp black, thermal black, or carbon fiber; metal powders or metal fibers made of copper, nickel, aluminum, silver, or the like; conductive whiskers of zinc oxide, potassium titanate, or the like; conductive metal oxides such as titanium oxide, or the like; a conductive polymer such as polyphenylene derivatives, and the like. One of them may be used alone or a mixture of two or more thereof may be used.

The positive electrode binder serves to improve adhesion between positive electrode active material particles and adhesion force between the positive electrode active material and the positive electrode current collector. Specific examples thereof may include polyvinylidene fluoride (PVDF), a vinylidenefluoride-hexafluoropropylene copolymer (PVDF-co-HFP), polyvinyl alcohol, polyacrylonitrile, carboxymethyl cellulose (CMC), starch, hydroxypropyl cellulose, regenerated cellulose, polyvinyl pyrrolidone, polytetrafluoroethylene, polyethylene, polypropylene, an ethylene-propylene-diene monomer (EPDM), sulfonated-EPDM, styrene butadiene rubber (SBR), fluorine rubber, and various copolymers thereof. One of them may be used alone or a mixture of two or more thereof may be used.

The separator, which separates the negative electrode and the positive electrode from each other and provides a movement path of lithium ions, is not particularly limited as long as it is used as a separator in a general secondary battery. Particularly, a separator having low resistance with respect to movement of ions of the electrolyte and having a high electrolyte-wetting ability is preferably used. Specifically, a porous polymer film, for example, a porous polymer film made of a polyolefin based polymer such as an ethylene homopolymer, a propylene homopolymer, an ethylene/butene copolymer, an ethylene/hexene copolymer, and an ethylene/methacrylate copolymer, or at least two layer laminates thereof may be used. In addition, general porous non-woven fabric, for example, non-woven fabric made of glass fiber having a high melting point, polyethylene terephthalate fiber, or the like, may be used. Further, in order to secure heat resistance or mechanical strength, a coated separator including a ceramic component or a polymer material may also be used, and a monolayer or multilayer structure may be selectively used.

Examples of the electrolyte may include organic liquid electrolytes that may be used at the time of manufacturing a lithium secondary battery, inorganic liquid electrolytes, solid polymer electrolytes, gel type polymer electrolytes, solid inorganic electrolytes, melting-type inorganic electrolytes, and the like, but are not limited thereto.

Specifically, the electrolyte may include a non-aqueous organic solvent and a metal salt.

As the non-aqueous organic solvent, non-aprotic organic solvents such as N-methyl-2-pyrrolidinone, propylene carbonate, ethylene carbonate, butylene carbonate, dimethyl carbonate, diethyl carbonate, gamma-butyrolactone, 1,2-dimethoxy ethane, tetrahydrofuran, 2-methyl tetrahydrofuran, dimethylsulfoxide, 1,3-dioxolane, formamide, dimethylformamide, dioxolane, acetonitrile, nitromethane, methyl formate, methyl acetate, phosphoric acid triester, trimethoxy methane, dioxolane derivatives, sulfolane, methyl sulfolane, 1,3-dimethyl-2-imidazolidinone, propylene carbonate derivatives, tetrahydrofuran derivatives, ether, methyl propionate, and ethyl propionate may be used.

Since among the carbonate based organic solvents, particularly, ethylene carbonate and propylene carbonate corresponding to cyclic carbonates, which are high-viscosity organic solvents, have high permittivity to dissociate lithium salts well, ethylene carbonate and propylene carbonate may be preferably used. In the case of using a mixture of the cyclic carbonate and a low-viscosity and low-permittivity linear carbonate such as dimethyl carbonate and diethyl carbonate at a suitable ratio, it is possible to prepare an electrolyte having high electrical conductivity, such that the electrolyte may be more preferably used.

As the metal salt, a lithium salt may be used, and the lithium salt is a material suitable for being dissolved in the non-aqueous electrolyte. As an anion of the lithium salt, for example, one or more selected from the group consisting of $F^-$, $Cl^-$, $I^-$, $NO_3^-$, $N(CN)_2^-$, $BF_4^-$, $ClO_4^-$, $PF_6^-$, $(CF_3)_2PF_4^-$, $(CF_3)_3PF_3^-$, $(CF_3)_4PF_2^-$, $(CF_3)_5PF^-$, $(CF_3)_6P^-$, $CF_3SO_3^-$, $CF_3CF_2SO_3^-$, $(CF_3SO_2)_2N^-$, $(FSO_2)_2N^-$, $CF_3CF_2(CF_3)_2CO^-$, $(CF_3SO_2)_2CH^-$, $(SF_5)_3C^-$, $(CF_3SO_2)_3C^-$, $CF_3(CF_2)_7SO_3^-$, $CF_3CO_2^-$, $CH_3CO_2^-$, $SCN^-$, and $(CF_3CF_2SO_2)_2N^-$ may be used.

In order to improve lifecycle characteristics of the battery, suppress a decrease in capacity of the battery,

improve discharge capacity of the battery, and the like, the electrolyte further include one or more additives, for example, a haloalkylene carbonate based compounds such as difluoroethylene carbonate, pyridine, triethyl phosphate, triethanolamine, cyclic ether, ethylene diamine, n-glyme, hexaphosphoric triamide, a nitrobenzene derivative, sulfur, a quinine imine dye, N-substituted oxazolidinone, N,N-substituted imidazolidine, ethylene glycol dialkyl ether, ammonium salt, pyrrole, 2-methoxy ethanol, or ammonium trichloride in addition to the above-mentioned components constituting the electrolyte.

According to another exemplary embodiment of the present disclosure, there are provided a battery module including the secondary battery as a unit cell, and a battery pack including the battery module. Since the battery module and the battery pack includes the secondary battery having high capacity, high rate performance, and cycle characteristics, the battery module and the battery pack may be used as a power source of a medium-large device selected from the group consisting of an electric vehicle, a hybrid electric vehicle, a plug-in hybrid electric vehicle, and a power storage system.

## Example

Hereinafter, Examples will be provided in order to assist in the understanding of the present disclosure. However, it will be obvious to those skilled in the art that the following Examples are only examples of the present disclosure and various modifications and alterations may be made without departing from the scope and spirit of the present disclosure. In addition, these modifications and alterations will fall within the following claims.

## Example 1

Powder in which Si and $SiO_2$ were mixed at a molar ratio of 1:1 was vacuum-heated at 1,400°C, thereby forming SiO vapor. Further, Mg was vacuum-heated at 700°C, thereby forming Mg vapor.

The SiO vapor and the Mg vapor were mixed at a weight ratio of 95:5 and reacted with each other in a cooling zone of 500°C to prepare Mg-SiO condensed in a solid phase, followed by grinding using a ball mill, thereby preparing powder (silicon based particles) having a size of 5 μm.

$n_5$-$(C_5H_5)_2Fe$ corresponding to a metallocene catalyst was mixed with ethanol, and mist of 1 wt% $n_5$-$(C_5H_5)_2Fe$ was prepared using a mist generator (17 Mhz, and 30 W conditions).

The Mg-SiO powder was positioned in a hot zone of a CVD device while maintaining an inert gas atmosphere by flowing Ar gas, and a reaction was carried out for 30 seconds while blowing the mist into a hot zone of 1000°C using Ar as carrier gas, thereby preparing a negative electrode active material in which a carbon coating layer including Fe was formed on a surface of Mg-SiO and carbon nanotubes were grown from Fe included in the carbon coating layer.

## Example 2

An negative electrode active material was prepared by the same method as in Example 1 except that a time consumed to perform the reaction while blowing the mist into the hot zone of 1000°C in Example 1 was 10 minutes.

## Example 3

An negative electrode active material was prepared by the same method as in Example 1 except that a time consumed to perform the reaction while blowing the mist into the hot zone of 1000°C in Example 1 was 300 minutes.

### Comparative Example 1

The Mg-SiO powder prepared in a process of Example 1 was used as a negative electrode active material.

### Comparative Example 2

The Mg-SiO powder prepared in the process in Example 1 was positioned in a hot zone of a CVD device while maintaining an inert gas atmosphere by flowing Ar gas and a reaction was carried out at $10^{-1}$ torr for 20 minutes while blowing methane into a hot zone of 900°C using Ar as carrier gas, thereby preparing a negative electrode active material in which a carbon coating layer was formed on a surface of Mg-SiO.

### Experimental Example 1: Measurement of Content of Fe

A content of Fe in the respective negative electrode active materials prepared in Examples 1 to 3 and Comparative Examples 1 and 2 was measured by an inductively coupled plasma (ICP) analysis method using an ICP optical emission spectrophotometers (ICP-OES; Optima 7300DV, manufactured by PerkinElmer).

A content (unit: parts by weight) of Fe based on 100 parts by weight of a sum of the carbon coating layer and the carbon nanotubes was shown in the following Table 1.

**Experimental Example 2: Evaluation of Initial Efficiency**

<Manufacture of Secondary Battery>

Respective active materials in which natural graphite and the negative electrode active materials prepared in Examples 1 to 3 and Comparative Examples 1 and 2 were mixed at a weight ratio of 95:5, respectively, Super-C65, carboxymethyl cellulose (CMC), and styrene butadiene rubber (SBR) were mixed at a weight ratio of 95.3:1.5:1.2:2 in water corresponding to a solvent, respectively, thereby preparing negative electrode slurry. The prepared negative electrode slurry was applied on a copper (Cu) thin film, a negative electrode current collector, having a thickness of about 15 μm, roll-pressed so as to have an electrode density of 1.6 g/cc, and then dried, thereby manufacturing a negative electrode.

After a propylene separator was interposed between a lithium metal as a counter electrode and the respective negative electrodes prepared above, an electrolyte was prepared by dissolving 1M $LiPF_6$ after adding 1.5 wt% of vinylene carbonate (VC) and 0.5 wt% of propane sultone (PS) to a solvent in which ethylene carbonate (EC) and ethyl methyl carbonate (EMC) was mixed at a volume ratio of 30:70, and then the electrolyte was injected, thereby manufacturing a half-cell battery.

<Evaluation of Initial Efficiency>

The half-cell batteries manufactured using the negative electrode active materials prepared in Examples 1 to 3 and Comparative Examples 1 and 2, respectively, were charged and discharged, and initial efficiency thereof was evaluated. The results were shown in the following Table 1.

The respective batteries prepared above were charged at 25°C with a constant current (CC) of 0.1 C until 5 mV, and then charged with a constant voltage (CV) until a charge current was 0.005 C (cut-off current), such that one-cycle charge was performed. After the respective batteries were allowed to stand for 20 minutes, the respective cells were discharged until 1.0 V with a constant current (CC) of 0.1 C, thereby confirming initial efficiency.

**Experimental Example 3: Evaluation of Life Characteristics**

Initial efficiency was evaluated by performing charge and discharge of the respective half-cell batteries prepared in Experimental Example 2, and the results were shown in the following Table 1.

The respective batteries prepared above were charged at 25°C with a constant current (CC) of 0.1 C until 5 mV, and then charged with a constant voltage (CV) until a charge current was 0.005 C (cut-off current), such that one-cycle charge was performed. After the respective batteries were allowed to stand for 20 minutes, the respective cells were discharged until 1.0 V with a constant current (CC) of 0.1 C, thereby confirming initial efficiency. Thereafter, the second charge and discharge cycle was performed with a constant current (CC) of 0.1 C, and then, charge and discharge cycles were repeated with a constant current (CC) of 0.1 C up to 50 cycles, thereby evaluating a capacity retention rate.

The capacity retention rate (%) was calculated by the following Equation.

$$\text{Capacity retention rate (\%)} = (\text{discharge capacity at } 50^{th} \text{ cycle/ discharge capacity at first cycle}) \times 100$$

[Table 1]

| | Carbon coating layer | Content (parts by weight) of Fe (based on 100 parts by weight of sum of carbon coating layer and carbon nanotubes) | Initial efficiency (%) | Capacity retention rate (%) |
|---|---|---|---|---|
| Example 1 | O | 0.05 | 90 | 83 |
| Example 2 | O | 1.0 | 90 | 87 |

(continued)

| | Carbon coating layer | Content (parts by weight) of Fe (based on 100 parts by weight of sum of carbon coating layer and carbon nanotubes) | Initial efficiency (%) | Capacity retention rate (%) |
|---|---|---|---|---|
| Example 3 | O | 30 | 84 | 87 |
| Comparative Example 1 | X | 0 | 85 | 75 |
| Comparative Example 2 | O | 0 | 90 | 80 |

Referring to Table 1, it may be confirmed that both initial efficiency and the capacity retention rates of the batteries using the negative electrode active materials in Examples 1 to 3 were excellent. On the contrary, the battery using the negative electrode active material in Comparative Example 1, which did not include a carbon coating layer, a carbon nanotubes, and a transition metal, did not have excellent initial efficiency and capacity retention rate. Particularly, the capacity retention rate was relatively significantly decreased. Further, it may be confirmed that in the case of the battery using the negative electrode active material in Comparative Example 2 in which only a carbon coating layer that did not include a transition metal was formed on a surface of a silicon based particle and carbon nanotubes were not included, initial efficiency was significantly improved, but an increase in capacity retention rate was restrictive.

According to the results of Examples 1 to 3 and Comparative Examples 1 and 2, the negative electrode active material including the carbon coating layer formed on the surface of the silicon based particle and carbon nanotubes grown from a transition metal included in the carbon coating layer may simultaneously exhibit excellent initial efficiency and life characteristics. However, in the case in which only the carbon coating layer was formed on the surface of the silicon based particle, initial efficiency was improved, but an effect of improving life characteristics was insufficient. Meanwhile, it may be confirmed through comparison of Examples 1 to 3 that an increase in content of the transition metal included in the carbon coating layer and an increase in amount of included carbon nanotubes caused thereby lead to increase the capacity retention rate, thereby improving life characteristics, but, in the case in which the content of the transition metal is equal to or more than a predetermined value, the initial efficiency was rather decreased.

## Claims

**1.** An negative electrode active material comprising:

a silicon based particle;
a carbon coating layer formed on a surface of the silicon based particle and including a transition metal; and carbon nanotubes (CNT),
wherein one ends of the carbon nanotube is connected to the transition metal, and a content of the transition metal is 0.03 to 30 parts by weight based on 100 parts by weight of a total weight of the carbon coating layer and the carbon nanotubes.

**2.** The negative electrode active material according to claim 1, wherein the one end of the carbon nanotube contacts with the carbon coating layer or is embedded in the carbon coating layer, and the other end of the carbon nanotube is positioned outside a surface of the carbon coating layer.

**3.** The negative electrode active material according to claim 1, wherein the transition metal is one or more selected from the group consisting of Cr, Mn, Fe, Co, Ni, and V.

**4.** The negative electrode active material according to claim 1, wherein the silicon based particle is one or more selected from the group consisting of Si, $SiO_x$($0<x<2$), and M-$SiO_y$ (M is Li, Mg, Ca, Al, or Ti, and $0\leq y<2$).

**5.** The negative electrode active material according to claim 1, wherein the silicon based particle is M-$SiO_y$ (M is Li, Mg, Ca, Al, or Ti, and $0\leq y<2$), and M-$SiO_y$ includes one or more selected from the group consisting of a Si phase, a $SiO_2$ phase, a metal oxide phase, and a metal silicate phase.

**6.** The negative electrode active material according to claim 5, wherein the metal silicate is one or more selected from

the group consisting of $Li_2Si_2O_5$, $Li_3SiO_3$, $Li_4SiO_4$, $Mg_2SiO_4$, and $MgSiO_3$.

**7.** An negative electrode comprising the negative electrode active material according to claim 1.

**8.** A lithium secondary battery comprising the negative electrode according to claim 7.

**9.** A method of preparing a negative electrode active material, comprising:

preparing a mixture including a transition metal compound and a carbon source; and
forming a carbon coating layer including a transition metal and carbon nanotubes (CNT) on a surface of a silicon based particle by conducting a chemical vapor deposition of the mixture on the surface of the silicon based particle,
wherein a content of the transition metal is 0.03 to 30 parts by weight based on 100 parts by weight of a total weight of the carbon coating layer and the carbon nanotubes.

**10.** The method according to claim 9, wherein the carbon nanotube grows using the transition metal of the transition metal compound as a catalyst and the carbon source and hydrocarbon of the transition metal compound as raw materials.

**11.** The method according to claim 9, wherein the transition metal compound is a compound represented by the following Chemical Formula 1:

[Chemical Formula 1]

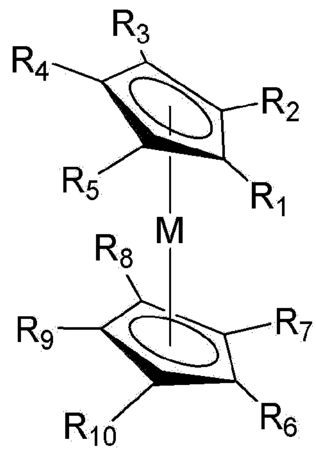

in Chemical Formula 1,

$R_1$ to $R_{10}$ are each independently hydrogen; halogen; silyl; (C1-C20)alkyl; (C3-C20)cycloalkyl; (C2-C20)alkenyl; (C1-C20)alkoxy; (C6-C20)aryl substituted or unsubstituted with halogen, (C1-C12)alkyl, (C3-C12)cycloalkyl, (C1-C8)alkoxy, or (C6-C12)aryl; or (C7-C20)arylalkyl substituted or unsubstituted with halogen, (C1-C12)alkyl, (C3-C12)cycloalkyl, (C1-C8)alkoxy, or (C6-C12)aryl; and two or more of $R_1$ to $R_{10}$ may be linked with each other to form a ring, and
M is V, Cr, Mn, Fe, Co, or Ni.

**12.** The method according to claim 9, wherein the carbon source is an alcohol based solvent.

**13.** The method according to claim 9, wherein the mixture is obtained by dispersing or dissolving the transition metal compound in the carbon source, and the chemical vapor deposition is conducted using the mixture in a liquid mist form as a raw material.

**14.** The method according to claim 9, wherein a content of the transition metal included in the carbon coating layer is adjusted depending on a chemical vapor deposition time, and the chemical vapor deposition is conducted for 6 seconds to 300 minutes.

【FIG. 1】

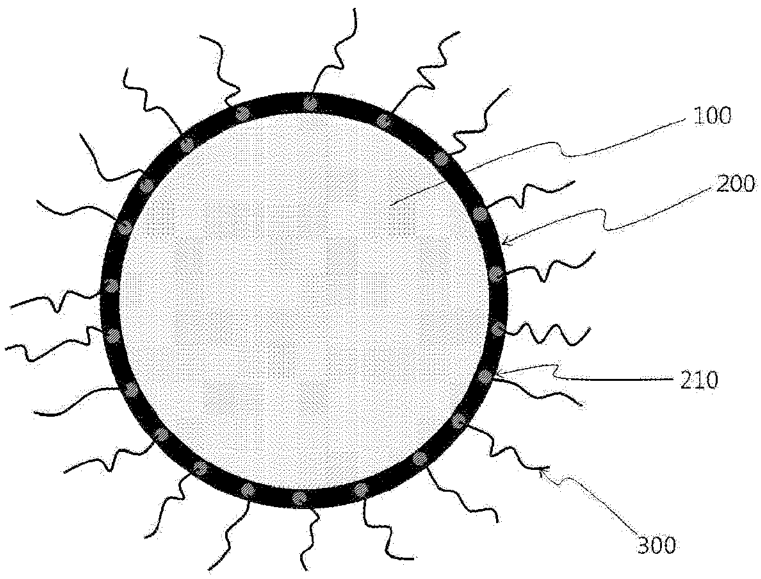

**INTERNATIONAL SEARCH REPORT**

International application No.
**PCT/KR2019/015245**

A. CLASSIFICATION OF SUBJECT MATTER

***H01M 4/36(2006.01)i, H01M 4/38(2006.01)i, H01M 4/48(2010.01)i, H01M 4/587(2010.01)i, H01M 4/62(2006.01)i, H01M 10/052(2010.01)i, C23C 16/18(2006.01)i, C23C 16/26(2006.01)i, C23C 16/448(2006.01)i***

According to International Patent Classification (IPC) or to both national classification and IPC

B. FIELDS SEARCHED

Minimum documentation searched (classification system followed by classification symbols)

H01M 4/36; B82Y 40/00; H01M 4/38; H01M 4/48; H01M 4/58; H01M 4/583; H01M 4/587; H01M 4/62; H01M 10/052; C23C 16/18; C23C 16/26; C23C 16/448

Documentation searched other than minimum documentation to the extent that such documents are included in the fields searched

Korean utility models and applications for utility models: IPC as above

Japanese utility models and applications for utility models: IPC as above

Electronic data base consulted during the international search (name of data base and, where practicable, search terms used)

eKOMPASS (KIPO internal), STN (Registry, Caplus) & Keywords: anode active material, silicon, carbon coating layer, transition metal catalyst, carbon nanotube, metallocene, chemical vapor deposition

C. DOCUMENTS CONSIDERED TO BE RELEVANT

| Category* | Citation of document, with indication, where appropriate, of the relevant passages | Relevant to claim No. |
|---|---|---|
| X<br><br>Y | KR 10-1607232 B1 (SAMSUNG ELECTRONICS CO., LTD.) 29 March 2016<br>See claims 1, 3, 6-10; paragraphs [0003], [0004], [0036]-[0040]; figure 1. | 1-4,7,8<br><br>5,6,9-14 |
| Y | KR 10-1610995 B1 (LG CHEM, LTD.) 08 April 2016<br>See claims 1, 2, 9; paragraph [0013]. | 5,6 |
| Y | JANTHARAMATSAKARN, K. et al. Ferrocene-ethanol-mist CVD grown SWCNT films as transparent electrodes. Procedia engineering. 2014, vol. 93, pages 49-58<br>See 2. Experimental section. | 9-14 |
| Y | KR 10-0840459 B1 (MATSUSHITA ELECTRIC INDUSTRIAL CO., LTD.) 20 June 2008<br>See claims 1, 2, 7, 10-12, 14; paragraphs [0029], [0037], [0039], [0063], [0066], [0073]; figure 1. | 1-4,7,8 |
| Y | KR 10-2010-0014993 A (KOREA KUMHO PETROCHEMICAL CO., LTD. et al.)<br>12 February 2010<br>See claims 1-3, 5, 6; paragraphs [0012], [0026], [0027], [0034], [0036]-[0038]. | 1-4,7,8 |

☐ Further documents are listed in the continuation of Box C.  ☒ See patent family annex.

* Special categories of cited documents:

"A" document defining the general state of the art which is not considered to be of particular relevance

"E" earlier application or patent but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 20 FEBRUARY 2020 (20.02.2020) | **20 FEBRUARY 2020 (20.02.2020)** |
| Name and mailing address of the ISA/KR<br>Korean Intellectual Property Office<br>Government Complex Daejeon Building 4, 189, Cheongsa-ro, Seo-gu, Daejeon, 35208, Republic of Korea<br>Facsimile No. +82-42-481-8578 | Authorized officer<br><br>Telephone No. |

Form PCT/ISA/210 (second sheet) (January 2015)

**INTERNATIONAL SEARCH REPORT**
Information on patent family members

International application No.
**PCT/KR2019/015245**

| Patent document cited in search report | Publication date | Patent family member | Publication date |
|---|---|---|---|
| KR 10-1607232 B1 | 29/03/2016 | KR 10-2010-0112442 A | 19/10/2010 |
| | | US 2010-0261050 A1 | 14/10/2010 |
| | | US 2014-0127558 A1 | 08/05/2014 |
| | | US 8663836 B2 | 04/03/2014 |
| | | US 9508987 B2 | 29/11/2016 |
| KR 10-1610995 B1 | 08/04/2016 | CN 104620427 A | 13/05/2015 |
| | | CN 104620427 B | 24/04/2018 |
| | | EP 2768051 A1 | 20/08/2014 |
| | | EP 2768051 B1 | 26/04/2017 |
| | | JP 2015-508559 A | 19/03/2015 |
| | | JP 6072070 B2 | 01/02/2017 |
| | | KR 10-2014-0070261 A | 10/06/2014 |
| | | US 2014-0205907 A1 | 24/07/2014 |
| | | US 9627681 B2 | 18/04/2017 |
| | | WO 2014-084502 A1 | 05/06/2014 |
| KR 10-0840459 B1 | 20/06/2008 | CN 100511781 C | 08/07/2009 |
| | | CN 101010820 A | 01/08/2007 |
| | | KR 10-2007-0088534 A | 29/08/2007 |
| | | US 2009-0004564 A1 | 01/01/2009 |
| | | WO 2006-067891 A1 | 12/06/2008 |
| KR 10-2010-0014993 A | 12/02/2010 | KR 10-1113008 B1 | 13/03/2012 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020180139256